# EUROPEAN PATENT APPLICATION

(11) **EP 0 678 592 A1**
(43) Date of publication of application: **25.10.1995**
(21) Application number: 95302221.7
(22) Date of filing: 03.04.1995
(51) Int. Cl.: C23C 16/26, C30B 25/02, C30B 29/04

(54) **Improved CVD diamond**

(30) Priority: 20.04.1994 US 230268
(71) Applicant: GENERAL ELECTRIC COMPANY, Schenectady, NY 12345 (US)
(72) Inventor: Anthony, Thomas Richard, Niskayuna, New York 12309 (US); Williams, Bradley Earl, Worthington, Ohio 43085 (US)
(74) Representative: Szary, Anne Catherine

(57) **Abstract**

In process for producing a CVD optically transparent film of at least 100 microns and having a thermal conductivity greater than about 20 W/cm-K, a gaseous mixture comprising hydrogen and an isotopically enriched source of carbon is passed over a substrate for a sufficient time period to deposit a diamond film having a thickness greater than about 50 microns.

## Description

The present invention relates to chemically vapor deposited (CVD) diamond.

Due to its high thermal conductivity, thick free-standing films of CVD diamond are currently being used as heat spreaders for laser diodes and electronic circuits. A problem common to all current CVD growth techniques is that for each process as the growth rate increases, the thermal conductivity decreases. This limits the practical growth rate of these processes since a minimum thermal conductivity of about 10watts/cm-K is required for most applications. Thus, it is desirable to rapidly grow high purity diamond having high thermal conductivity. In addition, some heat sink applications require a thermal conductivity that exceeds the maximum thermal conductivity of natural diamond of 22 watts/cm-K. It has previously been found that isotopically pure ¹²C single-crystal diamond grows as the high-pressure, high-temperature process has a thermal conductivity up to 32 watts/cm-K. However, this process is extremely expensive and thereby limits the potential use of isotopically pure diamond to a few applications.

It is object of the invention to rapidly grow high purity diamond having high thermal conductivity at a rapid rate.

Embodiments of the invention variously provide an isotopic enriched non-opaque diamond; the growth of isotopically enriched diamond at a much reduced cost than heretofore has previously been possible; and the growth of a new type of diamond with a thermal conductivity greater than that of a single-crystal natural isotope abundance diamond.

In accordance with one embodiment, there is provided a process for producing a CVD optically transparent film of at least 50 microns in thickness and having a thermal conductivity greater than about 20 W/cm-K comprising passing a gaseous mixture comprising hydrogen and carbon over a substrate for a sufficient time period to deposit a diamond film having a thickness greater than about 50 microns, said gaseous carbon consisting of an isotopically enriched carbon, (said carbon to hydrogen ratio being maintained, optionally within the ratio of .02 to .1 for enhancing the optical transparency of the resulting diamond), said process being continued until said film has a thickness of at least 50 microns, and removing said film from said substrate.

Isotopically pure diamond is grown on a substrate from a gaseous reaction mixture containing a hydrocarbon gas wherein the carbon in the hydrocarbon molecule is substantially entirely isotopically pure carbon-12 or carbon-13. Preferably the available carbon in the gaseous reaction mixture is greater than 99 percent by weight of either ¹²C or ¹³C. The preferred hydrocarbon gas is methane. A high purity isotopically pure methane is available from Cambridge Isotope laboratories Inc., 20 Commerce Way, Woburn, Massachusetts 01801.

Typically, processes for producing low pressure CVD diamond comprise microwave CVD, RFCVD, DCjet CVD, combustion flame CVD, or hot filament CVD. For short deposition times, the preferred process of the present invention is a microwave process. A filament process for forming a CVD diamond substrate as set forth in U.S. patent 5,110,579 to Anthony et al may also be utilized. According to the processes set forth in the patent, diamond is grown by chemical vapor deposition on a substrate by passing a mixture of methane and hydrogen over a filament for an appropriate length of time to form a film of the desired thickness.

The conditions during deposition are desirable uniformly maintained to obtain optically transparent diamond. Preferably, the reactants are selected so as to maintain impurities is at a very low level and the diamond CVD film consists entirely of diamond. Additional ingredients in the form of impurities and intentional additives are preferably present in amounts less than 4000 parts per million by weight, and more preferably less than 100 parts per million. The low level of impurities contributes to enhanced properties of the final CVD diamond. It is desirable to maintain a suitable substrate temperature and volume percent hydrogen based on the total volume of hydrogen and methane in said mixture at a suitable volume percent of hydrogen for saturating unsaturated carbon to rendering said film transparent. Preferred substrate temperatures are from about 600°C to about 1100°C and preferably from about 750°C to about 1000°C. Preferred percentages of methane or hydrogen are from about .2% to about 10%, and more preferably from about 1% to about 5% based on the volume.

The crystal size of the starting CVD diamond may vary greatly and is dependent on the nucleation of diamond. With a continued nucleation during the deposition process, submicron crystals of diamond may be attained. When the nucleation is limited to an initial nucleation at the substrate, elongated diamond crystals up to the thickness of the substrate may be formed.

The resulting CVD diamond film preferably has a thermal conductivity of at least about 20 W/cm-K, more preferably at least about 23 W/cm-K. Thermal conductivity of the diamond film may be as high as about 40 W/cm-K. One technique which can be used to measure thermal conductivity of the substantially transparent diamond film is by Mirage, shown by R.W. Pryor et al., proceedings of the Second International Conference on New Diamond Science and Technology, p 863 (1990).

The present invention also contemplates improving the properties of other types of diamond parts, especially free standing diamond windows, heat sinks, diamond electronic components, and diamond wear parts.

Typically, preferred thickness of the resulting CVD diamond for preferred applications is at greater than 50 microns with thicknesses greater than from 0.2 to 10 millimeter, preferably from 0.3 to 1.2 millimeters. Preferred optical properties include an absorbance of less than about 1.6cm⁻¹ when using light having a wavelength in the range between about 300 to 1400 nanometers. Over this range, the absorbance decreases linearly from about 1.6cm⁻¹ to 0.2cm⁻¹ as the wavelength increases from 300 to 1400 nanometers. The absorbance decreases from 0.2cm⁻¹ to less than 0.1cm⁻¹ as the wavelength increases from about 1400nm to about 2400nm.

The resulting diamond film preferably has good optical properties and can transmit light. The preferred diamond is optically transparent. Typical crystal orientations are <110>, <100>, <111> orientation. It is also contemplated that the diamond grains may have a random orientation. If the grain size of the CVD diamond is sufficiently small, random crystallographic orientations may be obtained.

For enhanced optical properties, the diamond preferably has grain boundaries between adjacent diamond crystals having hydrogen atoms saturating dangling carbon bonds. The concentrations of hydrogen in atomic per cent are typically from 10 ppm to about 1000 ppm, preferably from about 10 ppm to 500 ppm. A preferred diamond body has no voids greater than 20, and preferably no greater than 10 microns in diameter or inclusions of another material or carbon phase.

The preferred optical properties are non-opaque or transparent or translucent and contains oxygen in atomic percent greater than 1 part per billion. Undesirable impurities in the form of catalyst material, such as iron, nickel, or cobalt are preferably present in amounts less than 10 parts per million in atomic per cent. These impurities are typically associated with competing high-pressure high-temperature diamond synthesis process. Nitrogen may be present in the CVD diamond film in atomic per cent from between 0.1 to 1000 parts per million.

When preferred starting CVD diamond films are produced by deposition on substrates made of Si, Ge, Nb, V, Ta, Mo, W, Ti, Zr or Hf, by neutron activation analysis, we have found that small amounts of these substrate materials are incorporated into the CVD diamond films made on these substrates. Hence, the film may contain greater than 10 parts per billion and less than 10 parts per million of Si, Ge, Nb, V, Ta, Mo, W, Ti, Zr or Hf. Additionally, the film may contain more than one part per million of a halogen, i.e. fluorine, chlorine, bromine, or iodine. Additional additives may include N, B, O, and P which may be present in the form of intentional additives. These latter materials may be added as intentional additives to during CVD deposition such as by microwave diamond forming processes.

By way of further explanation, boron can be an intentional additive that is used to reduce intrinsic stress in the CVD diamond film or to improve the oxidation resistance of the film. Typically boron may present in atomic per cent from between 1-4000 ppm. Preferably additives such as N, S, Ge, Al, and P, are each present at levels less than 100 ppm. It is contemplated that suitable films may be produced at greater levels. Lower levels of impurities tend to favor desirable properties of toughness and wear resistance. The most preferred films contain less than 5 parts per million and preferably less than 1 part per million impurities and intentional additives. In this regard, hydrogen, and oxygen are not regarded as intentional additives or impurities since these ingredients are the result of the process. As previously set forth, the present invention contemplates production of such high purity starting CVD diamond by a variety of techniques such as microwave CVD, RFCVD, DCjet CVD, or combustion flame CVD.

### Example 1

An isotopically pure CVD diamond film was grown using a mixture of C12 methane, oxygen, and hydrogen in a microwave CVD reactor. The reactor was a model PDS 18 available from Applied Science and Technology, Woburn, MA. The reactor was equipped with an evacuation device so as maintain a reduced pressure of about 110 Torr. The feed gas comprised a mixture of 97.5 percent hydrogen, 0.4 percent oxygen, and 1.6 percent C12 methane. A molybdenum substrate was maintained at a temperature of 800 degrees Centigrade. The flow rate of the gaseous mixture was about 500 sccm through the reactor. The deposition was carried out for 3 days to obtain a thickness of 175 microns. The rate of diamond deposition is about 2.4 micron per hour. The growth conditions such as temperature, pressure, and gas composition, were precisely controlled to promote the growth of a high quality diamond film. At the end of the desired growth period a 175 µm diamond was achieved on the molybdenum substrate. Upon cooling the substrate to ambient temperatures, the diamond film separated from the substrate so a resulting free standing film was obtained. The thermal conductivity of natural abundance CVD diamond films grown in the manner described above are typically 12-16 W/cm-K. When measured by the thermal wave technique at Wayne State University, the isotopically pure diamond film of the as grown in this example had a measured value of 21.3 to 22.6 watts/cm-K which is significantly higher than the previously measured values.

## Claims

1. A process for producing a CVD optically transparent film of at least 50 microns in thickness and having a thermal conductivity greater than about 20 W/cm-K comprising passing a gaseous mixture comprising hydrogen, carbon, and other additional species over a substrate for a sufficient time period to deposit a diamond film having a thickness greater than about 50 microns, said carbon source consisting of an isotopically enriched carbon, said process being continued until said film has a thickness of at least 50 microns, and removing said film from said substrate.

2. A process according to Claim 1 comprising maintaining a suitable substrate temperature and volume percent hydrogen based on the total volume of hydrogen and carbon in said mixture at a suitable volume percent of hydrogen for saturating unsaturated carbon and rendering said film transparent.

3. A process according to Claim 1 wherein said carbon source is comprised of isotopically enriched methane, either C/2 or C/3 enriched.

4. A process according to Claim 1 wherein said gaseous mixture comprises hydrogen, oxygen, and an isotopically enriched carbon source.

5. A process according to Claim 1 wherein said substrate has a temperature from about 600 to about 1100 degrees Centigrade during said deposition.

6. A process according to Claim 1 depositing continues until said film has a thickness of at least 500 microns.

7. A process according to claim 1 wherein said deposition is from a microwave energized plasma at a rate of about 0.5 to about 5 microns per hour.

8. A process according to claim 1 wherein said deposition is from a hot filament energized gas at a rate of about 0.5 to about 5 microns per hour.

9. A process according to claim 1 wherein said diamond crystals being formed during said deposition have at least 50% of the carbon atoms being tetrahedrally bonded.

10. A process according to claim 1 comprising substantially saturating carbon atoms at diamond grain boundaries.
